# EUROPEAN PATENT SPECIFICATION

(11) **EP 2 472 623 B1**
(45) Date of publication and mention of the grant of the patent: **04.05.2016**
(21) Application number: 11195576.1
(22) Date of filing: 23.12.2011
(51) Int. Cl.: H01L 41/187, B41J 2/16, H01L 41/08

(54) **Liquid ejecting head, liquid ejecting apparatus and piezoelectric element**
Flüssigkeitsausgabekopf, Flüssigkeitsausgabevorrichtung und piezoelektrisches Element
Tête d'éjection de liquide, appareil d'éjection de liquide et élément piézoélectrique

(30) Priority: 28.12.2010 JP 2010294296
(43) Date of publication of application: 04.07.2012
(73) Proprietor: Seiko Epson Corporation, Shinjuku-ku Tokyo (JP)
(72) Inventor: Miyazawa, Hiromu, Nagano 392-8502 (JP); Yonemura, Takayuki, Nagano 392-8502 (JP); Morozumi, Koichi, Nagano 392-8502 (JP)
(74) Representative: Hoffmann Eitle

(56) References cited:
- US-A1- 2010 245 493
- US-A1- 2010 308 692
- XIUZHANG WANG ET AL: "Enhanced ferroelectric properties of Ce-substituted BiFeO3 thin films prepared by sol-gel process", JOURNAL OF SOL-GEL SCIENCE AND TECHNOLOGY, KLUWER ACADEMIC PUBLISHERS, BO, vol. 47, no. 2, 16 June 2008 (2008-06-16), pages 124-127, XP019610476, ISSN: 1573-4846

## Description

### BACKGROUND

### 1. Technical Field

The present invention relates to a liquid ejecting head and liquid ejecting apparatus having a piezoelectric element causing a pressure change in a pressure generating chamber communicating with a nozzle opening and having a piezoelectric layer and an electrode through which a voltage is applied to the piezoelectric layer, and the piezoelectric element.

### 2. Related Art

A piezoelectric actuator for a liquid ejecting head may use a piezoelectric element configured by interposing a piezoelectric layer made of piezoelectric material showing an electromechanical conversion function, for example crystallized dielectric material, between two electrodes. As a representative example of the liquid ejecting head, there is an ink jet recording head in which a pressure generating chamber communicating with a nozzle opening discharging ink droplets is partially configured as a vibration plate so that the ink in the pressure generating chamber is pressed due to transformation of the vibration plate by the piezoelectric element to be discharged as ink droplets from the nozzle opening.

The piezoelectric material used for the piezoelectric layer (piezoelectric ceramic) of the piezoelectric element requires high piezoelectric features, and lead zirconate titanate (PZT) is provided as a representative example (JP-A-2001-223404).

However, from the viewpoint of environmental problems, a piezoelectric material with a suppressed lead content is demanded. As a piezoelectric material not containing lead, there is BiFeO₃ having a Perovskite-type structure expressed by ABO₃. Here, A and B of ABO₃ represent an A site and a B site, which are, respectively, sites where oxygen is 12-coordinated and 6-coordinated. However, the BiFeO₃-based piezoelectric material has low insulation and tends to cause a leakage current. If a leakage current occurs easily, particularly when a high voltage is applied, cracks may be easily generated, and so the material is not suitable for use in a liquid ejecting head. A piezoelectric material for such use should have a high insulation of e.g. 1×10⁻³A/cm² or less when a representative driving voltage of 25 V is applied.

In addition, this problem is present not only in the ink jet recording head, but also in other liquid ejecting heads which discharge liquid droplets other than ink and in the piezoelectric element used for equipment other than the liquid ejecting heads. Further, the leakage current problem causes a serious problem of an increase in energy consumption when the piezoelectric element is used as a sensor. Thus, a low leakage current is desirable even for piezoelectric elements used for piezoelectric sensors, infrared sensors, temperature sensors and pyroelectric sensors to which a voltage of 1 V or less is applied.

Prior art example may be found in patent application document US2009/0308692 and also in Xiuzhang Wang et al: "Enhanced ferroelectric properties of Ce-substituted BiFe03 thin films prepared by sol-gel process", Journal of Sol-Gel Science and Technology, Kluwer Academic Publishers, PD - 2008-06-16, Vol. 47 nr. 2 page 124 - 127.

### SUMMARY

An advantage of some aspects of the invention is that it provides a liquid ejecting head, a liquid ejecting apparatus and a piezoelectric element which is environmentally friendly, and in which the piezoelectric material is highly insulating so that leakage current is suppressed.

According to an aspect of the invention, there is provided a piezoelectric element comprising a piezoelectric layer and an electrode connected to the piezoelectric layer, wherein the piezoelectric layer comprising a complex oxide having a Perovskite-type structure (ABO₃) comprising bismuth and iron, the complex oxide further comprising (i) a first dopant selected from the group consisting of sodium, potassium, calcium, strontium and barium and (ii) a second dopant which is cerium.

In this aspect, the piezoelectric element has high insulation so that leakage current is suppressed, resulting in great durability. In addition, since lead is not contained, the burden on the environment may decrease.

Bismuth the first doping element and the second doping element are included in an A site, and the iron is included in a B site.

Here, it is preferable that the complex oxide has a deficit at the A site of the complex oxdie having the Perovskite-type structure and has Bi at the B site.

In addition, it is preferable that the complex oxide further include barium titanate in addition to bismuth and iron. By doing so, the liquid ejecting head may have a piezoelectric element with further superior piezoelectric characteristics (amount of deformation).

According to another aspect of the invention, there is provided a liquid ejecting head, which comprises a pressure generating chamber communicating with a nozzle opening; and a piezoelectric element as defined above.

In this aspect, since the piezoelectric element has high insulation due to the suppression of leakage current, it is possible to implement a liquid ejecting head with excellent durability. In addition, since lead is not contained, the burden on the environment may decrease.

According to still another aspect of the invention, there is provided a liquid ejecting apparatus including the liquid ejecting head defined above.

In this aspect, it is possible to implement a piezoelectric element with excellent insulation so that leakage current is suppressed. In addition, since lead is not contained, the burden on the environment may decrease.

### BRIEF DESCRIPTION OF THE DRAWINGS

The invention will be described with reference to the accompanying drawings, wherein like numbers reference like elements.
Fig. 1 is an exploded perspective view showing a schematic configuration of a recording head according to a first embodiment.
Fig. 2 is a plan view of the recording head according to the first embodiment.
Fig. 3 is a cross-sectional view of the recording head according to the first embodiment.
Fig. 4 is a diagram showing density of electron states of BiFeO₃ perfect crystal.
Fig. 5 is a diagram showing density of electron states when Bi of BiFeO₃ has a 12.5% defect at an A site.
Fig. 6 is a diagram showing density of electron states when 12.5% of iron of BiFeO₃ at a B site is substituted with Bi.
Fig. 7 is a diagram showing density of electron states when 12.5% of transition metal at the B site is substituted with Pb for Pb(Zr,Ti)O₃.
Fig. 8 is a diagram showing density of electron states when 4% of oxygen loss occurs in an oxygen site of BiFeO₃.
Fig. 9 is a schematic diagram illustrating hopping conduction in a crystal of complex oxide.
Fig. 10 is a schematic diagram illustrating hopping conduction in a crystal of complex oxide according to the invention.
Fig. 11 is a diagram showing density of electron states when 12.5% of Bi of BiFeO₃ at the A site is substituted with Na.
Fig. 12 is a diagram showing density of electron states when 12.5% of Bi of BiFeO₃ at the A site is substituted with K.
Fig. 13 is a diagram showing density of electron states when 12.5% of Bi of BiFeO₃ at the A site is substituted with Ca.
Fig. 14 is a diagram showing density of electron states when 12.5% of Bi of BiFeO₃ at the A site is substituted with Sr.
Fig. 15 is a diagram showing density of electron states when 12.5% of Bi of BiFeO₃ at the A site is substituted with Ba.
Fig. 16 is a diagram showing density of electron states when 12.5% of Bi of BiFeO₃ at the A site is substituted with Ce.
Figs. 17A and 17B are cross-sectional views showing the recording head manufacturing process according to the first embodiment.
Figs. 18A to 18C are cross-sectional views showing the recording head manufacturing process according to the first embodiment.
Figs. 19A and 19B are cross-sectional views showing the recording head manufacturing process according to the first embodiment.
Figs. 20A to 20C are cross-sectional views showing the recording head manufacturing process according to the first embodiment.
Figs. 21A and 21B are cross-sectional views showing the recording head manufacturing process according to the first embodiment.
Fig. 22 is a diagram showing a schematic configuration of a recording apparatus according to an embodiment of the invention.

### DESCRIPTION OF EXEMPLARY EMBODIMENTS

### First Embodiment

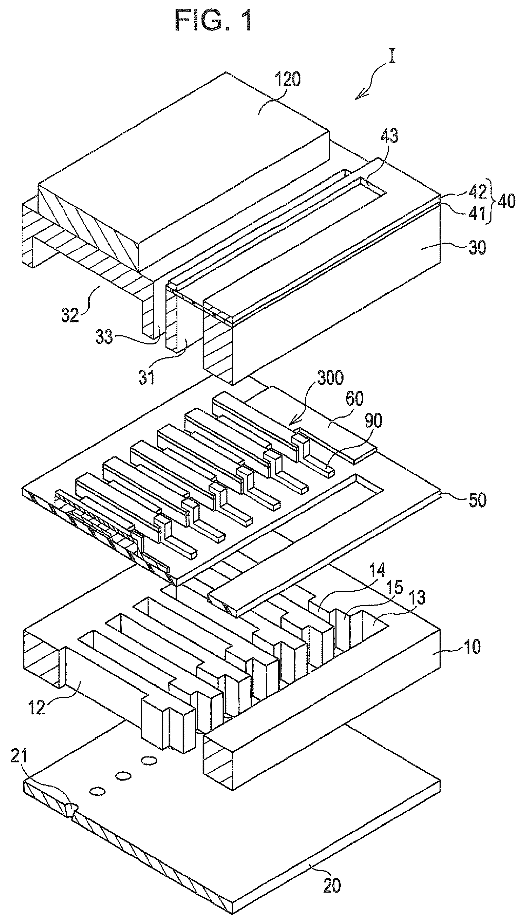

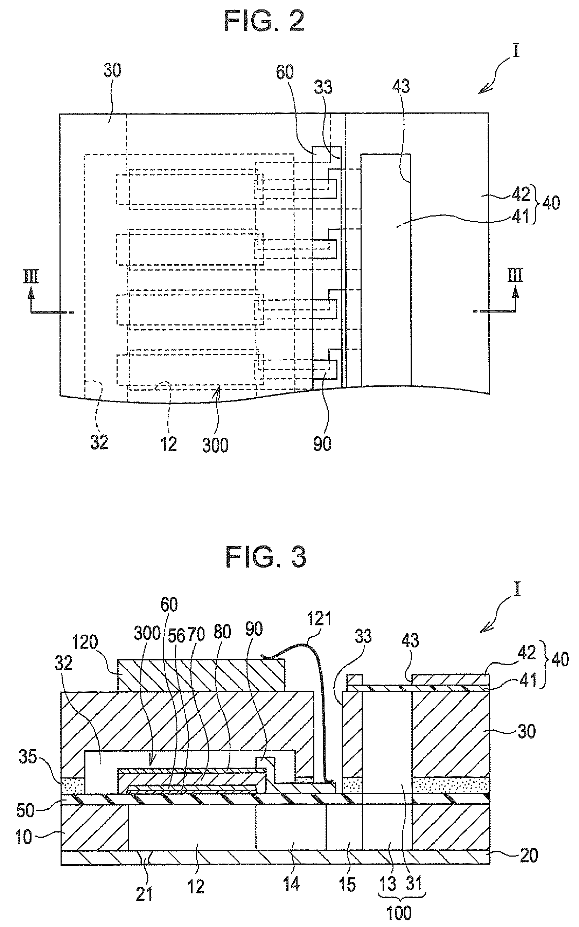

Fig. 1 is an exploded perspective view showing a schematic configuration of an ink jet recording head which is an example of a liquid ejecting head according to a first embodiment of the invention, Fig. 2 is a plan view of Fig. 1, and Fig. 3 is a cross-sectional view taken along the line III-III in Fig. 2. As shown in Figs. 1 to 3, a channel-formed substrate 10 of this embodiment is formed with a silicon single crystal substrate, and an elastic film 50 made of silicon dioxide is formed on one surface thereof.

A plurality of pressure generating chambers 12 are installed to the channel-formed substrate 10 in the width direction thereof. In addition, a communication portion 13 is formed in the outer portion of the pressure generating chamber 12 of the channel-formed substrate 10 in the longitudinal direction so that each pressure generating chamber 12 communicates with the communication portion 13 via an ink supply path 14 and a communication path 15 installed for each pressure generating chamber 12. The communication portion 13 communicates with a manifold portion 31 of a protective substrate described later to configure a part of a manifold which becomes a common ink chamber of each pressure generating chamber 12. The ink supply path 14 is formed with a smaller width than the pressure generating chamber 12 so that a channel resistance of the ink introduced from the communication portion 13 to the pressure generating chamber 12 is maintained consistently. In addition, even though the ink supply path 14 is formed by squeezing the channel in the width direction from one side in this embodiment, the ink supply path 14 may also be formed by squeezing the channel in the width direction from both sides. In addition, the ink supply path may also be formed by squeezing the channel not in the width direction but in the thickness direction. In this embodiment, a liquid channel composed of the pressure generating chamber 12, the communication portion 13, the ink supply path 14 and the communication path 15 is installed to the channel-formed substrate 10.

In addition, a nozzle plate 20 in which a nozzle opening 21 communicating with the vicinity of the end portion of each pressure generating chamber 12 opposite to the ink supply path 14 is formed is adhered to the opening surface side of the channel-formed substrate 10 by means of an adhesive or thermal adhesion film. In addition, the nozzle plate 20 is made of, for example, glass ceramics, silicon single crystal substrate, stainless steel, or the like.

Meanwhile, the elastic film 50 is formed at the side of the channel-formed substrate 10 opposite to the opening surface, as described above, and an adhesive film 56 made of titanium oxide with, for example, a thickness of about 30 to 50 nm to improve adhesion with the base of a first electrode 60 of the elastic film 50 is installed on the elastic film 50. In addition, an insulator film made of zirconium oxide may also be installed on the elastic film 50 as necessary.

Further, the first electrode 60, a thin-film piezoelectric layer 70 with a thickness of 2 µm or less, and preferably 0.3 to 1.5 µm, and a second electrode 80 are laminated on the adhesion film 56 to configure a piezoelectric element 300. Here, the piezoelectric element 300 is defined as including the first electrode 60, the piezoelectric layer 70 and the second electrode 80. Generally, any one electrode of the piezoelectric element 300 may be set to be a common electrode, and the electrode and the piezoelectric layer 70 are configured by patterning each pressure generating chamber 12. In this embodiment, the first electrode 60 is set to be a common electrode of the piezoelectric element 300, and the second electrode 80 is set to be an individual electrode of the piezoelectric element 300, but this configuration may be reversed in consideration of driving circuits or wirings. In addition, here, the piezoelectric element 300 and a vibration plate causing displacement by the operation of the corresponding piezoelectric element 300 are called an actuator device when combined. In addition, in the above example, the elastic film 50, the adhesion film 56, the first electrode 60, and the insulator film which is provided as necessary serve as the vibration plate, but, for example, the elastic film 50 or the adhesion film 56 may not be provided without being limited to the above. In addition, the piezoelectric element 300 itself may be configured to substantially serve as the vibration plate.

Hereinafter, the Perovskite-type structure of the complex oxide including transition metal is written as ABO₃. Here, the A site and the B site respectively represent sites where oxygen is 12-coordinated and 6-coordinated.

In this embodiment, the piezoelectric layer 70 is made of complex oxide having the Perovskite-type structure containing bismuth (Bi) and iron (Fe) and includes at least one first dopant selected from the group consisting of sodium (Na), potassium (K), calcium (Ca), strontium (Sr) and barium (Ba) and a second dopant which is cerium. By doing so, as described later, leakage current is suppressed, and insulation may be improved. In addition, since lead is not contained, the burden on the environment may decrease.

The complex oxide according to this embodiment may include bismuth at the A site of the Perovskite-type structure and iron at the B site, but the bismuth and iron at the A and B sites may be substituted with other elements. For example, a substitution element at the A site may be lanthanum, praseodymium, neodymium, samarium, yttrium, or the like, and a substitution element at the B site may be cobalt, chrome, manganese, nickel, copper, or the like.

Bismuth included in BiFeO₃ or the like may easily volatilize during the manufacturing process, particularly during the firing process of the piezoelectric layer, and may tend to cause crystal defects of the A site. The lost Bi diffuses in the conditions of a manufacturing chamber or toward the lower electrode. As Bi is released from the system, oxygen is lost in order to keep the balance of electron number. The ratio of Bi defects to oxygen defects is 2:3 in order to satisfy the charge neutrality principle. The presence of oxygen loss lowers the orbital energy of a d electron of the transition metal by means of Coulomb potential so that the band gap of the piezoelectric element is narrowed, which becomes a direct factor causing leakage current as a result. In order to suppress oxygen loss, it is desirable to suppress Bi loss. For this purpose, including an excess of Bi in advance in the stoichiometric composition may be considered, but the excess Bi is released into not only the A site but also the B site unintentionally at a consistent rate. Bi released into the B site becomes a source of an electron carrier, which causes a leakage current in the piezoelectric element. For this reason, in the system of BiFeO₃, it is difficult to use a manufacturing method where an excess of Bi is included in the stoichiometric composition.

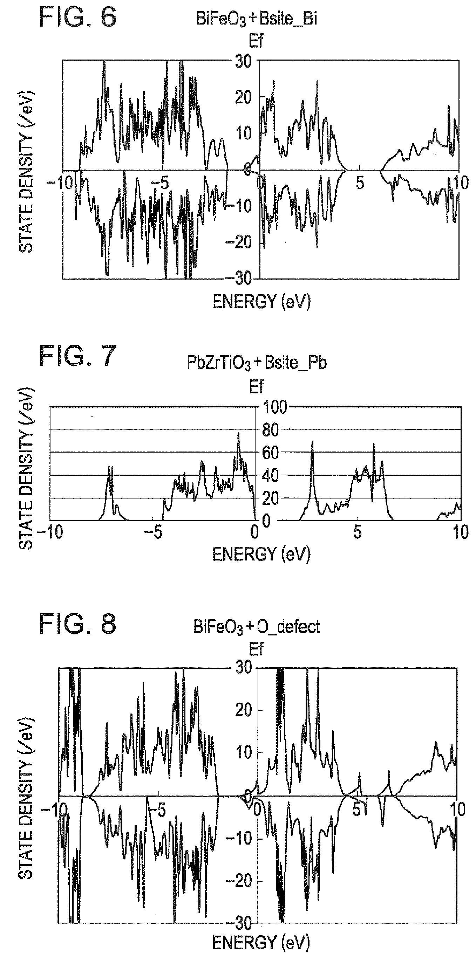

Here, in lead zirconate titanate (Pb(Zr,Ti)O₃: PZT) which was used in the related art, lead (Pb) may tend to volatilize during the manufacturing process, similar to Bi. For this reason, a method where an excess of Pb is included in the stoichiometric composition is used. The excess Pb causes a phenomenon in which Pb is released into the B site unintentionally. However, in the PZT, as shown in Fig. 7 described later, even though Pb is unintentionally included in the B site, the band gap in the electron structure may be maintained. For this reason, in a case where Pb(Zr,Ti)O₃ is manufactured, even if excess Pb is included in advance in the stoichiometric composition, the insulation of the piezoelectric body does not deteriorate.

After further investigating the above problems by using the ab initio electron state calculation, the following findings were obtained.

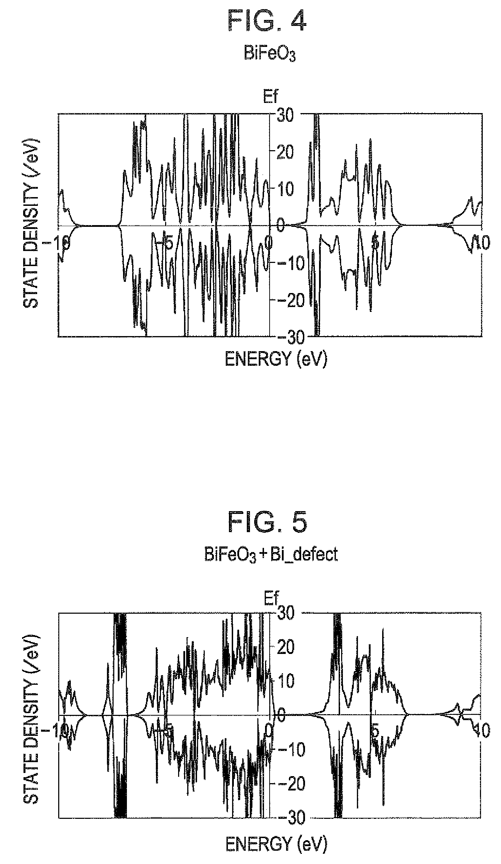

Figs. 4 to 8 are diagrams showing the density of electron states of each crystal, necessary for the ab initio electron state calculation, where the horizontal axis represents an energy difference (eV) of electrons and the vertical axis represents density of electron states (DOS: Density Of State). In addition, further to the plus side than the state density 0 (/eV) represents up-spin, and the minus side represents down-spin. As the condition for the ab initio electron state calculation, the ultra soft pseudopotential method based on the density functional approach in the range of the generalized gradient approximation (GGA) was used. For the transition metal atom of the B site, in order to give a strong correlation effect originated from the localization of the d electron orbit, the GGA+U method (GGA plus U method) was applied. The cutoffs of the wave function and the charge density were respectively 20 Hartree and 360 Hartree. The super cell of the crystal used for the calculation was configured by using an eight (2×2×2=8) ABO₃ type Perovskite-type structure. In addition, the mesh at the inverse lattice point (k point) was (4x4x4).

Fig. 4 is a diagram showing the density of electron states of a perfect crystal of bismuth ferric oxide (BiFeO₃), Fig. 5 is a diagram showing the density of electron states when 12.5% of Bi at the A site of bismuth ferric oxide (BiFeO₃) is defective, Fig. 6 is a diagram showing the density of electron states when 12.5% of Bi is substituted in the B site of bismuth ferric oxide (BiFeO₃), Fig. 7 is a diagram showing that 12.5% of Pb is substituted with lead zirconate titanate (Pb(Zr,Ti)O₃) in the B site, and Fig. 8 is a diagram showing the density of electron states when 4% loss occurs at the oxygen site of bismuth ferric oxide (BiFeO₃).

The system exhibits stable antiferromagnetic states in all of Figs. 4, 5, 6, 7 and 8.

As shown in Fig. 4, in the case of a perfect BiFeO₃ crystal, namely in a case where each site has no hole and Bi is not substituted with another element, the highest electron occupancy level (Ef) is the top of the valence band, and therefore the band gap is opened to ensure insulation. In Fig. 4, a side state in a lower energy for the band gap is a charged band, and a side state in a higher energy is a conductive band.

In addition, the highest electron occupancy level represents a level of the highest orbital energy occupied by electrons, which corresponds to one-electron energy capable of being obtained by the electron state simulation. In each graph of the density of electron states, the 0 point of the horizontal axis is set to be the highest electron occupancy level (Ef).

As shown in Fig. 5, for BiFeO₃, if bismuth (Bi) at the A site is partially lost and causes defects, the hole state density is shown further to the plus side than the energy of 0 eV. In other words, the highest electron occupancy level comes to be in the energy region of the valence band. Therefore, it can be understood that the insulation of the system is deteriorated to create hole carriers, and its electric conduction type is p-type. At this time, it can be understood that the loss of Bi at the A site gives three hole carriers, which requires the area of the hole state density.

In addition, as shown in Fig. 6, if bismuth (Bi) is included at the B site, the occupied state density appears further to the minus side than the energy of 0 eV. In other words, the highest electron occupancy level comes to be in the energy region of the conductive band. Therefore, the system is not insulating, and it can be understood that it becomes an n-type conductor since electron carriers are generated. At this time, it can be understood that Bi at the B site gives one electron carrier, which requires the area of the occupied state density.

In Fig. 7, the density of electron states where Pb is included at the B site in PZT is shown. In the PZT-based piezoelectric material, even though Pb is included in the B site, as shown in Fig. 7, the band gap in the electron structure may be maintained. Therefore, when Pb(Zr,Ti)O₃ is manufactured, even though a method of including an excess of Pb in the stoichiometric composition in advance is used, the insulation of the piezoelectric body does not deteriorate.

In addition, as shown in Fig. 8, if a 4% loss occurs at the oxygen site of BiFeO₃, the occupied state density is shown further to the minus side than the energy of 0 eV. In other words, the highest electron occupancy level comes to be in the energy region of the conductive band. Therefore, the system is not insulating, and it can be understood that it becomes an n-type conductor as electron carriers are generated. At this time, it can be understood that the loss of the oxygen site gives two electron carriers, which require the area of the occupied state density.

Therefore, as shown in Figs. 5, 6 and 8, in BiFeO₃, n-type defects and p-type defects can coexist. For example, in the case of a semiconductor, since carriers in the conductive band and the charged band have a free electron state, hole carriers originating from p-type defects and electron carriers originating from n-type defects spread spatially, which may be negative to each other. Meanwhile, in the case of transition metal oxide, carriers of the conductive band and the charged band are local and have low mobility. For this reason, hole carriers and electron carriers do not perfectly offset each other. For this reason, in the transition metal oxide, the carriers which have not been offset contribute to electric conduction of the system as hopping conduction.

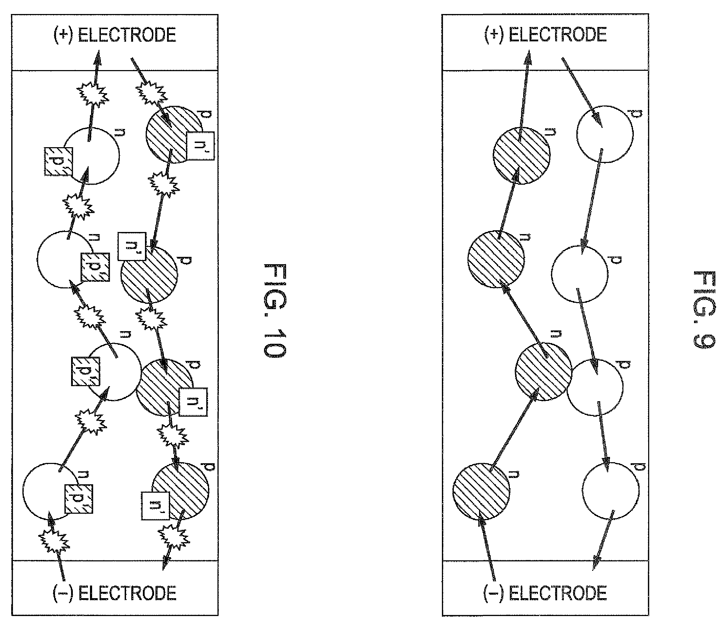

Fig. 9 schematically shows the hopping conduction state in the transition metal compound where p-type defects and n-type defects are present. As above, in the transition metal compound, for the p-type defects and the n-type defects, respectively, hopping conduction channels allowing movement of hole carriers and electron carriers are formed. In this circumstance, even though doping is conducted to compensate one of both carriers, the hopping conduction by one of both carriers may not be suppressed any more. This is considered to be a factor deteriorating the insulation properties of BiFeO₃.

Therefore, the generation of leakage current may not be prevented even though an n-type doping element which offsets p-type defects or a p-type doping element which offsets n-type defects is doped solely, but leakage current caused by p-type defects and leakage current caused by n-type defects may be prevented if the n-type dope electrode and the p-type dope electrode are doped together (co-doped).

The invention is based on the above knowledge, and the complex oxide which is transition metal compound of BiFeO₃ or the like is simultaneously doped (co-doped) with the n-type dopant and p-type dopant to prevent leakage current caused by p-type defects and leakage current caused by n-type leakage, thereby improving the insulating property.

Fig. 10 is a schematic diagram showing the transition metal compound of the invention simultaneously doped (co-doped) with the n-type doping element and the p-type doping element. As shown in Fig. 10, if the complex oxide which is a transition metal compound of BiFeO₃ is simultaneously doped (co-doped) with the n-type doping element and the p-type doping element, p-type defects are offset by the n-type doping element, and n-type defects are offset by the p-type doping element. For this reason, both the leakage current caused by hopping between n-type defects and the leakage current caused by hopping between p-type defects may be greatly reduced.

In other words, in the invention a perovskite oxide such as BiFeO₃ is simultaneously doped with at least one first dopant selected from the group consisting of sodium (Na), potassium (K), calcium (Ca), strontium (Sr) and barium (Ba) and a second dopant which is cerium (Ce).

Such dopants are substituted at the A site, where the first dopant becomes a p-type donor and offsets n-type defects and the second dopant becomes an n-type donor and offsets p-type defects.

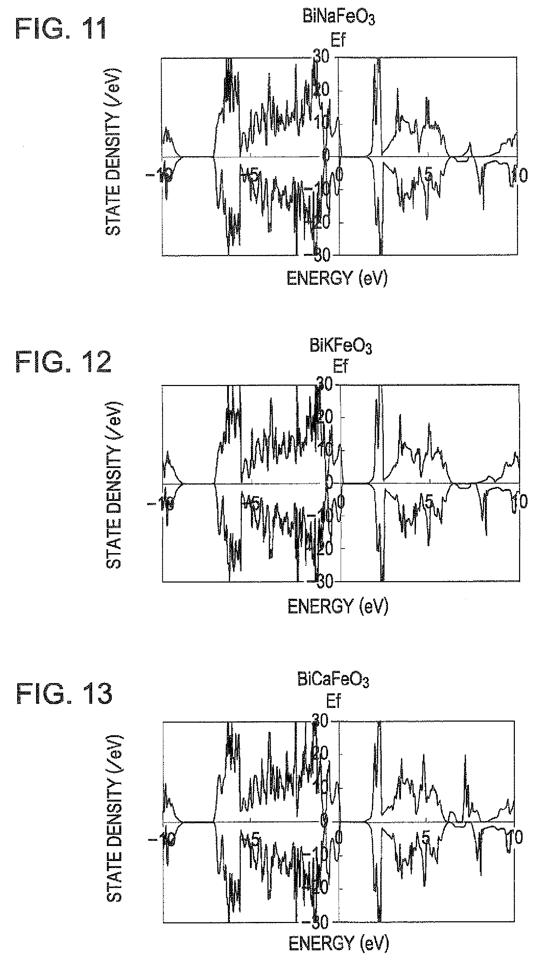

Figs. 11 to 16 are diagrams showing the density of electron states required for using the ab initio electron state calculation, for the crystal when 12.5% of Bi at the A site is substituted with sodium (Na), potassium (K), calcium (Ca), strontium (Sr), barium (Ba) and cerium (Ce), respectively. In addition, the conditions of the ab initio electron state calculation are identical to the above.

As shown in Figs. 11 to 15, if a part of bismuth (Bi) of BiFeO₃ is forcibly substituted with sodium (Na), potassium (K), calcium (Ca), strontium (Sr) and barium (Ba) (i.e. the first dopant), the hole state density is shown further to the plus side than the energy of 0 eV. In other words, the highest electron occupancy level comes to be in the energy region of the valence band. Therefore, it can be understood that the insulation of the system is deteriorated to create hole carriers, and its doping type is p-type. At this time, it can be understood that the first dopant for the A site results in hole carriers, which requires the area of the hole state density. In other words, in the case of Na and K, two hole carriers are given, and in the case of Ca, Sr and Ba, one hole carrier is respectively given. Therefore, it can be understood that each of sodium (Na), potassium (K), calcium (Ca), strontium (Sr) and barium (Ba) can serve as a p-type donor.

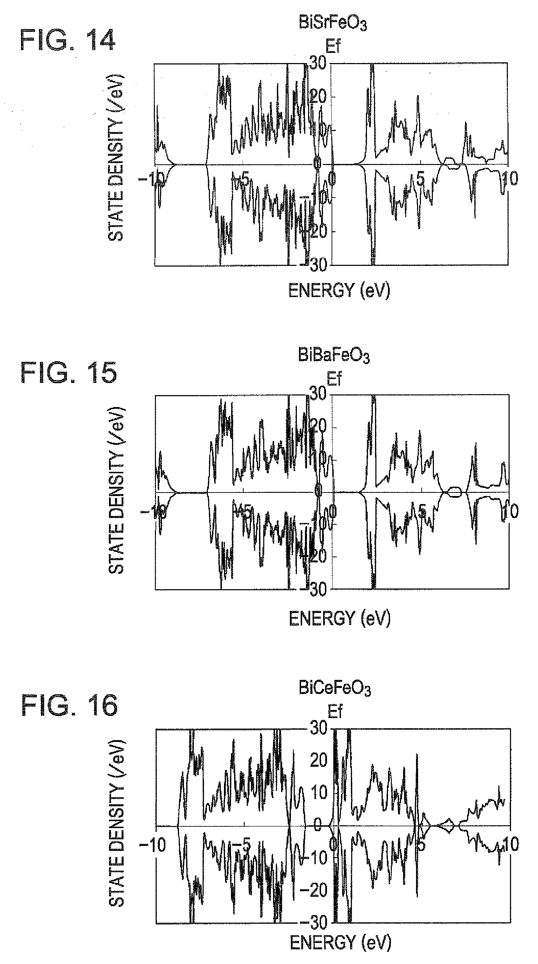

In addition, as shown in Fig. 16, if a part of bismuth (Bi) of BiFeO₃ is forcibly substituted with cerium (Ce) (i.e. the second dopant), the occupied state density appears further to the minus side than the energy of 0 eV. In other words, the highest electron occupancy level comes to be in the energy region of the valence band. Therefore, it can be understood that the insulation of the system is deteriorated to create hole carriers, thereby becoming n-type. At this time, it can be understood that Ce substituted at the A site gives one hole carrier, which requires the area of the hole state density. Therefore, it can be understood that cerium serves as an n-type donor.

As described above, in the invention, a perovskite oxide such as BiFeO₃ is doped with at least one first dopant selected from the group consisting of sodium (Na), potassium (K), calcium (Ca), strontium (Sr) and barium (Ba) to offset n-type defects and is doped with a second dopant which is cerium (Ce) to offset p-type defects, and therefore a high insulating property may be maintained.

These dopants do not perfectly eliminate bismuth defects themselves even though they are located at the A site. In other words, atom defects of the A site and the first and second dopants of the A site may co-exist. For example, even when bismuth defects occur at the A site, the dopant does not come into a location where bismuth comes out, but in a state where such a bismuth defect is present, the dopant substitutes an element such as Bi or the like in another A site to be doped. In addition, the inclusion of a dopant at a B site offsets bismuth (p-type) of the B site and bismuth defects (n-type) of the A site.

Here, at least one first dopant selected from the group consisting of sodium (Na), potassium (K), calcium (Ca), strontium (Sr) and barium (Ba) preferably dopes an amount corresponding to the expected amount of n-type defects, and the second dopant which is cerium (Ce) preferably dopes an amount corresponding to the expected amount of p-type defects. For this reason, for example, a suitable amount of doping is 10 mol% or less, and preferably 5 mol% or less (based on the total amount of A-site atoms). In addition, the first dopant may include two or more of the above-listed dopants.

Such a dopant is distinguished from an element of the Perovskite-type structure which becomes a component, and is doped according to an amount of defects generated in the crystal.

In the invention, the complex oxide may include lanthanum (which has a large ionic radius) at the A site. When lanthanum is included, it is possible to prevent a structure other than the Perovskite-type structure from appearing. Further, since lanthanum has a very weak covalent bonding property with the nearest oxygen, compared with bismuth, the potential barrier is lowered with respect to the rotation of the polarization moment by an applied electric field. The situation where the rotation of polarization moment occurs easily improves the piezoelectric characteristics. In addition, lanthanum is metal with ion valence of +3, and therefore even though those metal elements are present in the A site, "valence balance" of the invention does not change, and the situation of leakage current is not adversely affected. The content of lanthanum at the A site is preferably in the range of 5 mol% to 20 mol%, based on the total amount of bismuth, cerium and lanthanum. Praseodymium, neodymium, and samarium are also elements with large ionic radii having an ion valence of +3, and therefore provide the same effect as lanthanum.

In addition, the complex oxide may include cobalt (Co), chromium (Cr) or both, in addition to iron (Fe) at the B site. Such elements are preferably included in an amount of 12.5 to 87.5 mol%, based on the total amount of the elements at the B site. As described above, since the complex oxide includes iron, cobalt and chrome at a predetermined ratio at the B site, insulation and magnetism may be maintained. In addition, since the corresponding complex oxide has a morphotropic phase boundary (MPB), it may have excellent piezoelectric characteristics. In particular, when cobalt and/or chrome is included in a total amount of around 50 mol% with respect to the entire amount of iron, cobalt and chrome, for example, the piezoelectric constant increases due to the MPB, and therefore the piezoelectric characteristics are particularly improved.

Further, the complex oxide preferably further includes barium titanate (for example, BaTiO₃ with the Perovskite-type structure) of the stoichiometric composition, in addition to BiFeO₃. In this case, at room temperature, MPB appears between BiFeO₃ with a rhomborhedral structure and BaTiO₃ with a tetragonal structure. For this reason, the piezoelectric characteristics of the piezoelectric layer 70 are improved so that the vibration plate may make a big displacement even with a small voltage. Here, when the piezoelectric layer 70 includes barium titanate, for example, the complex oxide (for example, (Bi, Ba) (Fe, Ti) O₃) with the Perovskite-type structure formed with barium titanate and bismuth ferric acid which is a main component is doped with the first dopant and the second dopant simultaneously. In particular, when barium is selected as the first dopant, an excess of barium is added to barium titanate(BaTiO₃) of the stoichiometric composition.

The piezoelectric layer 70 of this embodiment has a monosymmetric crystal structure. In other words, the piezoelectric layer 70 made of the complex oxide with the Perovskite-type structure has a monoclinic symmetry. This piezoelectric layer 70 may obtain high piezoelectric properties. For this reason, a structure where the polarization moment of the piezoelectric layer may easily rotate may be conceived, regarding the electric field applied to a surface in the vertical direction. In the piezoelectric layer, the variation of the polarization moment is directly associated with the variation of the crystal structure, and therefore it securely comes to have the piezoelectric property. From the above, a high piezoelectric property may be obtained for the structure where polarization moment tends to change.

In addition, the piezoelectric layer 70 preferably has an engineered domain arrangement in which the polarization direction is inclined by a predetermined angle (50 degrees to 60 degrees) to the vertical direction to the film surface (the thickness direction of the piezoelectric layer 70).

A lead electrode 90 made of, for example, gold (Au) which is extracted from the vicinity of the end portion of the ink supply path 14 side and installed onto the elastic film 50, or even onto an insulator film which is prepared as necessary, is connected to each second electrode 80 which is an individual electrode of the piezoelectric element 300.

A protective substrate 30 having the manifold portion 31 configuring at least a part of the manifold 100 is adhered by means of an adhesive 35 on the channel-formed substrate 10 where the piezoelectric element 300 is formed, namely on the first electrode 60, the elastic film 50, the insulator film prepared as necessary, or the lead electrode 90. The manifold portion 31 is formed to extend in the width direction of the pressure generating chamber 12 to pass through the thickness direction of the protective substrate 30 in this embodiment to communicate with the communication portion 13 of the channel-formed substrate 10 as described above, thereby configuring the manifold 100 which becomes a common ink chamber of each pressure generating chamber 12. In addition, the communication portion 13 of the channel-formed substrate 10 may be divided in plural for each pressure generating chamber 12, and only the manifold portion 31 may be used as the manifold. Further, for example, it is possible to provide only the pressure generating chamber 12 to the channel-formed substrate 10 so that the ink supply path 14 communicating with each pressure generating chamber 12 is provided to a member (for example, the elastic film 50, the insulator film prepared as necessary, or the like) interposed between the channel-formed substrate 10 and the protective substrate 30 as the manifold 100.

In addition, a piezoelectric element holding unit 32 with a space not disturbing the movement of the piezoelectric element 300 is installed in a region opposite to the piezoelectric element 300 of the protective substrate 30. The piezoelectric element holding unit 32 has a space not disturbing the movement of the piezoelectric element 300, and the space may be sealed or not sealed.

The protective substrate 30 may be made of material with substantially the same coefficient thermal expansion as the channel-formed substrate 10, for example glass, ceramic material or the like, and in this embodiment, it is formed with a silicon single crystal substrate with the same material as the channel-formed substrate 10.

In addition, a through hole 33 formed to pass through the protective substrate 30 in the thickness direction is formed in the protective substrate 30. In addition, the vicinity of the end portion of the lead electrode 90 appearing from the piezoelectric element 300 is installed to expose in the through hole 33.

In addition, a driving circuit 120 for driving the installed piezoelectric element 300 is fixed on the protective substrate 30. The driving circuit 120 may use, for example, a circuit substrate, a semiconductor integrated circuit (IC), or the like. In addition, the driving circuit 120 and the lead electrode 90 are electrically connected via a connection wire 121 made of conductive wire such as bonding wire.

In addition, a compliance substrate 40 composed of a sealing film 41 and a fixed plate 42 is adhered on the protective substrate 30. Here, the sealing film 41 is made of material with flexibility and low rigidity, so that one side surface of the manifold portion 31 is sealed by the sealing film 41. In addition, the fixed plate 42 is made of relatively rigid material. Since a region of the fixed plate 42 opposite to the manifold 100 becomes an opening 43 perfectly removed in the thickness direction, the one side surface of the manifold 100 is sealed by only the sealing film 41 with flexibility.

In the ink jet recording head I of this embodiment, the ink is obtained from an ink inlet hole connected to an external ink supply unit (not shown) so that the inside is filled with the ink from the manifold 100 to the nozzle opening 21, and then voltage is applied between the first electrode 60 and the second electrode 80 respectively corresponding to the pressure generating chamber 12 according to the recording signal from the driving circuit 120 to flexural-deform the elastic film 50, the adhesion film 56, the first electrode 60 and the piezoelectric layer 70, so that the pressure in each pressure generating chamber 12 increases to discharge ink droplets from the nozzle opening 21.

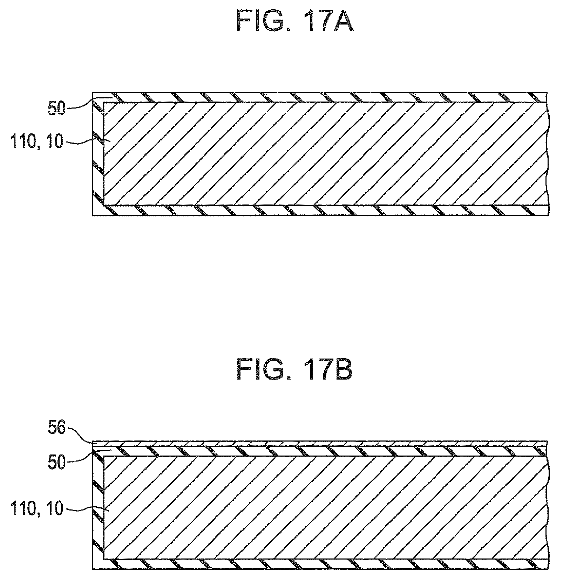

Next, an example of a method of manufacturing the ink jet recording head according to this embodiment will be described with reference to Figs. 17A to 21B. In addition, Figs. 17A to 21B are longitudinal cross-sectional views of the pressure generating chamber.

First, as shown in Fig. 17A, a silicon dioxide film made from silicon dioxide (SiO₂) or the like configuring the elastic film 50 is formed by thermal oxidation or the like on the surface of a wafer 110 for the channel-formed substrate which is a silicon wafer. Then, as shown in Fig. 17B, an adhesion film 56 made from titanium oxide or the like is formed by thermal oxidation or the like on the elastic film 50 (the silicon dioxide film).

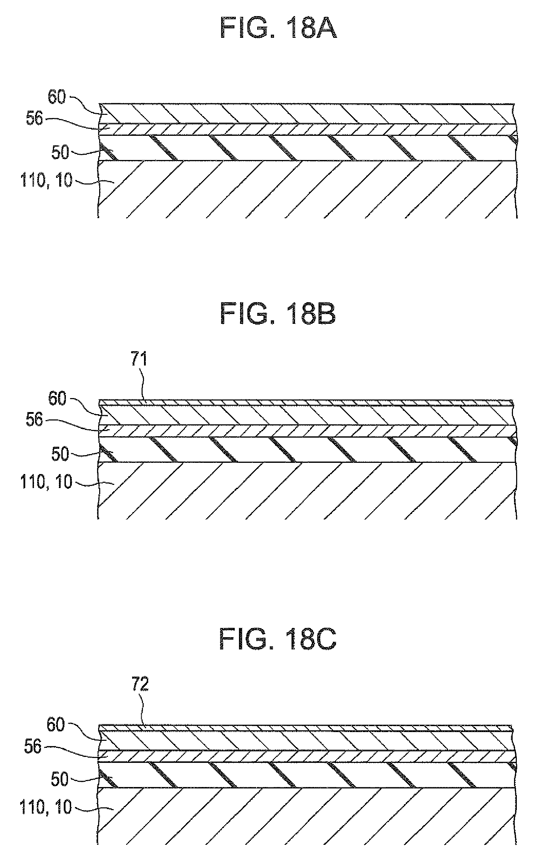

Next, as shown in Fig. 18A, a platinum film configuring the first electrode 60 is formed by sputtering or the like on the entire surface of the adhesion film 56.

After that, the piezoelectric layer 70 is laminated on the platinum film. The piezoelectric layer 70 may be formed by a metal organic decomposition (MOD) method which obtains a piezoelectric layer (or, a piezoelectric film) made from metal oxide by applying and drying a solution containing a metal complex and firing at a higher temperature, a chemical solution method such as a sol-gel method, or a vapor method such as sputtering. In addition, the piezoelectric layer 70 may also be formed by methods such as laser ablation, spattering, pulse laser deposition (PLD), CVD, aerosol deposition, or the like, other than the above.

Regarding the detailed forming order example of the piezoelectric layer 70, first, as shown in Fig. 18B, a metal complex, in detail, a sol or MOD solution (precursor solution) including a metal complex containing Bi and Fe, La contained as necessary or Co, Cr, and the first dopant and the second dopant at a desired composition ratio is applied on the first electrode 60 by spin coating or the like to form a piezoelectric precursor film 71 (a coating process).

The applied precursor solution is obtained by mixing a metal compound which may form a complex oxide containing (i) Bi and Fe, (ii) optionally one or more of La, Co and Cr, and (iii) the first dopant and the second dopant so that each metal has a desired mole ratio, and dissolving or dispersing the corresponding mixture with a compound containing nitrogen in an organic solvent such as alcohol or the like.

The term "metal compound which may form a complex oxide" used herein represents a mixture of one or more a metal compounds containing (i) Bi and Fe, (ii) optionally one ore more of La, Co and Cr, and (iii) the first dopant and the second dopant. The metal compounds respectively including the above components may be, for example, metal alkoxides, organic acid salts, β-diketone complexes, or the like.

The metal compound containing Bi may be, for example, 2-ethyl hexane acid bismuth or the like. The metal compound containing Fe may be, for example, 2-ethyl hexane acid iron or the like. The metal compound containing Co may be, for example, 2-ethyl hexane acid cobalt or the like. The metal compound containing Cr may be, for example, 2-ethyl hexane acid chromium or the like. The metal compound containing La may be, for example, 2-ethyl hexane acid lanthanum or the like. The metal compound containing Na may be, for example, 2-ethyl hexane acid sodium, sodium acetate, sodium acetylacetonate, sodium tert-butoxide, or the like. The metal compound containing K may be, for example, 2-ethyl hexane acid potassium, potassium acetate, potassium acetylacetonate, potassium tert-butoxide, or the like. The metal compound containing Ca may be, for example, 2-ethyl hexane acid calcium or the like. The metal compound containing Sr may be, for example, 2-ethyl hexane acid strontium or the like. The metal compound containing Ba may be, for example, 2-ethyl hexane acid barium or the like. The metal compound containing Ce may be, for example, 2-ethyle hexane acid cerium or the like. In addition, a metal compound containing two or more of Bi, Fe, Co and La may also be used.

After that, the piezoelectric precursor film 71 is dried for a predetermined time (a drying process) by heating at predetermined temperature (150 to 400°C). Next, the dried piezoelectric precursor film 71 is heated at predetermined temperature and kept for a predetermined time for degreasing (a degreasing process). In addition, the degreasing used herein means to make organic components included in the piezoelectric precursor film 71 be separated as, for example, NO₂, CO₂, H₂O or the like. The conditions of the drying process and the degreasing process is not limited, and may be performed in the atmosphere or in an inert gas.

Next, as shown in Fig. 18C, the piezoelectric precursor film 71 is crystallized by being heated at temperature of, for example, about 600 to 800°C, and kept for a predetermined time to form a piezoelectric film 72 (a firing process). Even in the firing process, the conditions are not limited, and this process may be performed in the atmosphere or in an inert gas.

In addition, a heating device used for the drying process, the degreasing process and the firing process may be, for example, a rapid thermal annealing (RTA) device for heating by the irradiation of infrared lamp, a hot plate or the like.

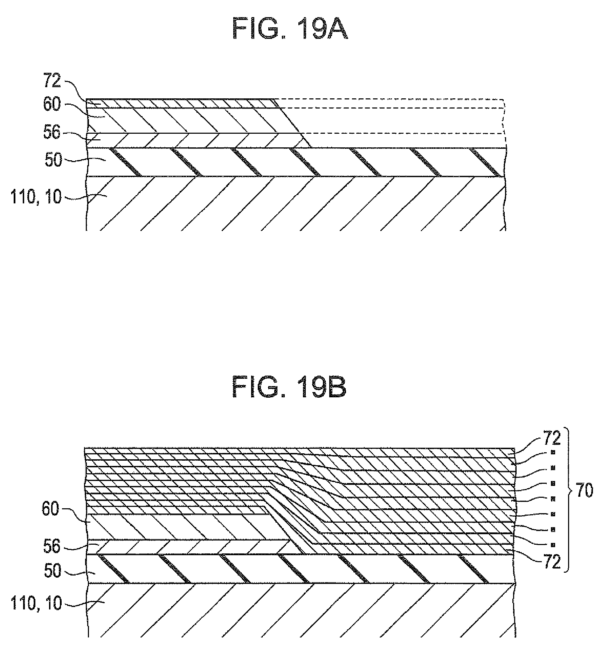

Next, as shown in Fig. 19A, a resist (not shown) of a predetermined shape is patterned on the piezoelectric film 72 as a mask so that the sides of the first electrode 60 and the piezoelectric film 72 are slanted with a first level.

After that, the resist is peeled off, and then the coating process, the drying process and the degreasing process, as described above, or the coating process, the drying process, the degreasing process and the firing process are repeated several times according to a desired film thickness to form the piezoelectric layer 70 composed of a plurality of piezoelectric films 72, and therefore the piezoelectric layer 70 of a predetermined thickness composed of a plurality of piezoelectric films 72 is formed as shown in Fig. 19B. For example, when the film thickness obtained by one coating process of the coating solution is about 0.1 µm, for example, the film thickness of the entire piezoelectric layer 70 composed of ten layers of the piezoelectric films 72 becomes about 1.1 µm. In addition, in this embodiment, even though the piezoelectric films 72 are laminated, it is also possible to use a single layer of the piezoelectric film 72.

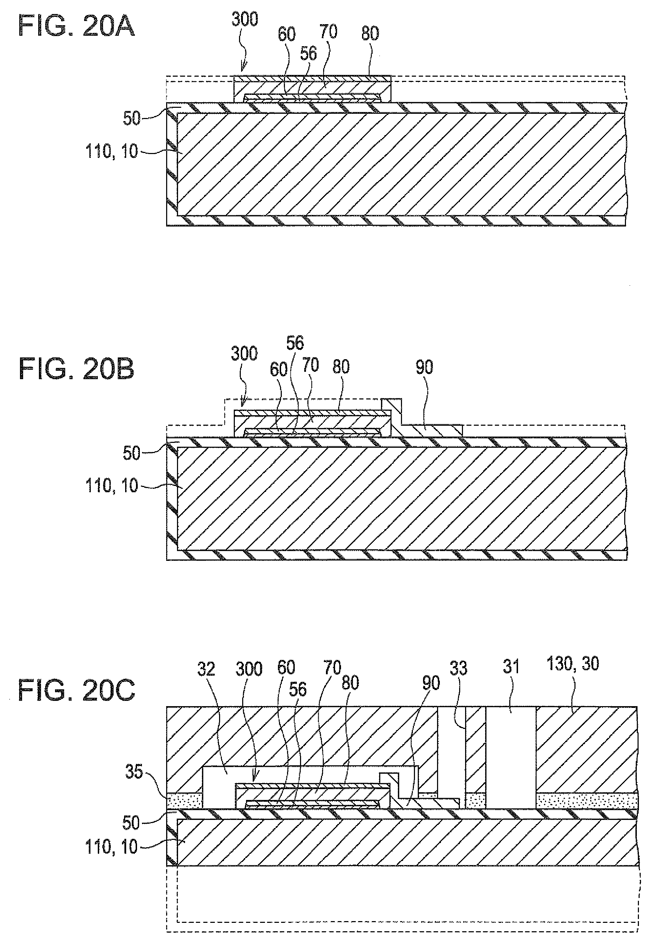

After the piezoelectric layer 70 is formed as described above, as shown in Fig. 20A, the second electrode 80 made of platinum or the like is formed on the piezoelectric layer 70 by sputtering or the like to pattern the piezoelectric layer 70 and the second electrode 80 together in a region opposite to each pressure generating chamber 12, and the piezoelectric element 300 is formed by the first electrode 60, the piezoelectric layer 70 and the second electrode 80. In addition, the patterning of the piezoelectric layer 70 and the second electrode 80 may be performed in a bundle by performing dry etching by means of a resist (not shown) formed with a predetermined shape. After that, as necessary, post-annealing may be performed in a temperature range of 600°C to 800°C. By doing so, an excellent interface may be formed between the piezoelectric layer 70 and the first electrode 60 or the second electrode 80, and the crystalline property of the piezoelectric layer 70 may be improved.

Next, as shown in Fig. 20B, the lead electrode 90 made of, for example, gold (Au) or the like is formed on the entire surface of a wafer 110 for the channel-formed substrate, and then each piezoelectric element 300 is patterned by means of a mask pattern (not shown) made of, for example, resist or the like.

Next, as shown in Fig. 20C, a wafer 130 for the protective substrate, which is a silicon wafer and becomes a plurality of protective substrates 30, is adhered by means of the adhesive 35 to the piezoelectric element 300 of the wafer 110 for the channel-formed substrate, and then the wafer 110 for the channel-formed substrate is processed to have a predetermined thin thickness.

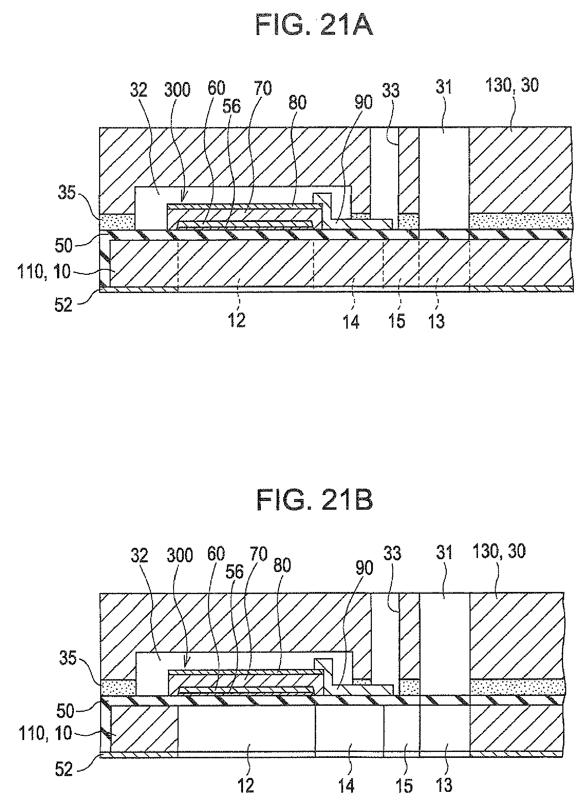

Next, as shown in Fig. 21A, a mask film 52 is newly formed on the wafer 110 for the channel-formed substrate to pattern a predetermined shape.

In addition, as shown in Fig. 21B, anisotropic etching (wet etching) using an alkali solution such as KOH is performed to the wafer 110 for the channel-formed substrate by using the mask film 52 to form the pressure generating chamber 12, the communication portion 13, the ink supply path 14, the communication path 15 or the like, which correspond to the piezoelectric element 300.

After that, unnecessary portions in the outer circumferences of the wafer 110 for the channel-formed substrate and the wafer 130 for the protective substrate are cut off by, for example, dicing or the like and removed. In addition, the mask film 52 at the surface of the wafer 110 for the channel-formed substrate, which is opposite to the wafer 130 for the protective substrate, is removed, and then the nozzle plate 20, in which the nozzle opening 21 is formed, is adhered thereto, and simultaneously, the compliance substrate 40 is adhered to the wafer 130 for the protective substrate so that the wafer 110 for the channel-formed substrate or the like is divided into the channel-formed substrates 10 with a tip size as shown in Fig. 1, thereby manufacturing the ink jet recording head I of this embodiment.

### Another Embodiment

Heretofore, one embodiment of the invention has been described, but the basic configuration of the invention is not limited to the above description. For example, even though the channel-formed substrate 10 is a silicon single crystal substrate in the above embodiment, for example, an SOI substrate or material such as glass or the like may be used, particularly without being limited to the above.

Further, even though the piezoelectric element 300 in which the first electrode 60, the piezoelectric layer 70 and the second electrode 80 are laminated in order on the substrate (the channel-formed substrate 10) as illustrated in the above embodiment, a vertical-vibrating piezoelectric element in which piezoelectric material and electrode-forming material are laminated with each other and extend or shrink in an axial direction may also be applied to the invention as an example, without being limited to the above.

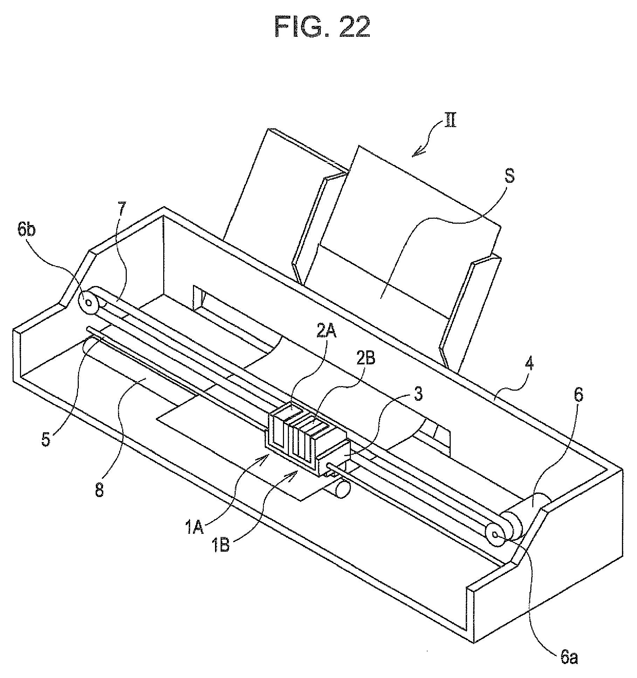

In addition, the ink jet recording head of these embodiments configures a part of a recording head unit having an ink channel communicating with an ink cartridge or the like and is installed in an ink jet recording apparatus. Fig. 22 is a schematic view showing an example of the ink jet recording apparatus II.

As shown in Fig. 22, the recording head units 1A and 1B having the ink jet recording head I include cartridges 2A and 2B serving as an ink supply unit detachably installed thereto, and a cartridge member 3 on which the recording head units 1A and 1B are loaded is installed to be movable in the axial direction of a cartridge member shaft 5 mounted to an apparatus body 4. The recording head units 1A and 1B discharge, for example, black ink composition and color ink composition, respectively.

In addition, the driving force of a driving motor 6 is transferred to the cartridge member 3 via a plurality of toothed wheels (not shown), and a timing belt 7, and the cartridge member 3 on which the recording head units 1A and 1B are loaded moves along the cartridge member shaft 5. Meanwhile, a platen 8 is installed to the apparatus body 4 along the cartridge member shaft 5 so that a recording sheet S which is a recording medium such as paper or the like fed by feeding rollers or the like (not shown) may be rolled around the platen 8 and carried out.

In the example shown in Fig. 22, the ink jet recording head units 1A and 1B respectively have a single ink jet recording head I, but one ink jet recording head unit 1A or 1B may have two or more ink jet recording heads as an example, without being limited to the above.

In addition, even though it has been described in the above embodiment that the ink jet recording head is an example of the liquid ejecting head, the invention is targeted at a broad range of liquid ejecting heads and may be applied to a liquid ejecting head which ejects liquid other than ink. Other liquid ejecting heads may include, for example, various kinds of recording heads used for an image recording apparatus such as a printer, color material ejecting heads used for making color filters of liquid crystal displays or the like, electrode material ejecting heads used for forming electrodes of organic EL displays, field emission displays (FED) or the like, biological organic substance ejecting heads used for making bio chips, or the like.

The piezoelectric element of the invention may be applied to a piezoelectric element of a liquid ejecting head, represented by an ink jet recording head, as described above in order to show good insulation and piezoelectric characteristics, but it is not limited thereto. For example, it may be applied to piezoelectric elements of ultrasonic devices of ultrasonic transmitters, ultrasonic motors, piezoelectric transformers, and various sensors such as infrared sensors, ultrasonic sensors, temperature sensors, pressure sensors, pyroelectric sensors or the like. In addition, the invention may be applied to ferroelectric elements such as ferroelectric memories or the like in the same manner.

## Claims

1. A piezoelectric element comprising:
a piezoelectric layer; and
an electrode connected to the piezoelectric layer,
wherein the piezoelectric layer comprises a complex oxide having a Perovskite-type structure (ABO₃) comprising bismuth and iron, the complex oxide further comprising (i) a first dopant selected from the group consisting of sodium, potassium, calcium, strontium and barium and (ii) a second dopant which is cerium, wherein the bismuth, the first doping element and the second doping element are included at an A site, and the iron is included at a B site of the perovskite complex oxide.

2. The piezoelectric element according to claim 1,
wherein the complex oxide comprises a defect at the A site and comprises Bi at the B site.

3. The piezoelectric element according to any preceding claim, wherein the complex oxide further comprises barium and titanium in addition to bismuth and iron.

4. A liquid ejecting head comprising:
a pressure generating chamber communicating with a nozzle opening; and
a piezoelectric element having a piezoelectric layer and an electrode provided at the piezoelectric layer,
wherein the piezoelectric layer is as defined in any preceding claim.

5. A liquid ejecting apparatus comprising the liquid ejecting head according to claim 4.

## Patentansprüche

1. Piezoelektrisches Element umfassend:
eine piezoelektrische Schicht und
eine mit der piezoelektrischen Schicht verbundene Elektrode,
worin die piezoelektrische Schicht ein Komplexoxid mit einer Perovskit-artigen Struktur (ABO₃) umfassend Bismut und Eisen umfasst, wobei das Komplexoxid ferner (i) einen ersten Dotanden, ausgewählt aus der Gruppe bestehend aus Natrium, Kalium, Calcium, Strontium und Barium, und (ii) einen zweiten Dotanden, der Cer ist, umfasst, wobei das Bismut, das erste Dotierungselement und das zweite Dotierungselement an einem A-Platz enthalten sind, und das Eisen an einem B-Platz des Perovskit-Komplexoxids enthalten ist.

2. Piezoelektrisches Element gemäß Anspruch 1, worin das Komplexoxid einen Defekt an dem A-Platz umfasst und Bi an dem B-Platz umfasst.

3. Piezoelektrisches Element gemäß irgendeinem der vorhergehenden Ansprüche, worin das Komplexoxid ferner Barium und Titan zusätzlich zu Bismut und Eisen umfasst.

4. Flüssigkeitsausstoßkopf umfassend:
eine Druckerzeugungskammer, die mit einer Düsenöffnung kommuniziert, und
ein piezoelektrisches Element mit einer piezoelektrischen Schicht und einer an der piezoelektrischen Schicht vorgesehenen Elektrode,
worin die piezoelektrische Schicht so wie in einem der vorhergehenden Ansprüche definiert ist.

5. Flüssigkeitsausstoßvorrichtung, umfassend den Flüssigkeitsausstoßkopf gemäß Anspruch 4.

## Revendications

1. Elément piézoélectrique, comprenant :
une couche piézoélectrique ; et
une électrode connectée à la couche piézoélectrique,
dans lequel la couche piézoélectrique comprend un oxyde complexe ayant une structure de type perovskite (ABO₃) comprenant du bismuth et du fer, l'oxyde complexe comprenant en outre (i) un premier dopant choisi dans le groupe constitué par le sodium, le potassium, le calcium, le strontium et le baryum et (ii) un second dopant qui est le cérium, dans lequel le bismuth, le premier élément de dopage et le second élément de dopage sont compris sur un site A et le fer est compris sur un site B de l'oxyde complexe de type perovskite.

2. Elément piézoélectrique selon la revendication 1, dans lequel l'oxyde complexe comprend un défaut sur le site A et comprend du Bi sur le site B.

3. Elément piézoélectrique selon l'une quelconque des revendications précédentes, dans lequel l'oxyde complexe comprend en outre du baryum et du titane en plus du bismuth et du fer.

4. Tête d'éjection de liquide, comprenant :
une chambre de génération de pression communiquant avec l'ouverture d'une buse ; et
un élément piézoélectrique comportant une couche piézoélectrique et une électrode disposée sur la couche piézoélectrique,
dans laquelle la couche piézoélectrique est telle que définie dans l'une quelconque des revendications précédentes.

5. Appareil d'éjection de liquide comprenant la tête d'éjection de liquide selon la revendication 4.
